(19) Europäisches Patentamt
European Patent Office
Office européen des brevets

(11) **EP 4 206 699 A1**

(12) **EUROPEAN PATENT APPLICATION**
published in accordance with Art. 153(4) EPC

(43) Date of publication:
**05.07.2023 Bulletin 2023/27**

(21) Application number: **21861054.1**

(22) Date of filing: **20.07.2021**

(51) International Patent Classification (IPC):
*G01R 31/08* (2020.01)        *G01R 31/58* (2020.01)

(52) Cooperative Patent Classification (CPC):
**G01R 31/08; G01R 31/58; Y02E 10/50**

(86) International application number:
**PCT/JP2021/027126**

(87) International publication number:
**WO 2022/044625 (03.03.2022 Gazette 2022/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.08.2020   JP 2020142532**

(71) Applicant: **Panasonic Intellectual Property
Management Co., Ltd.
Osaka-shi, Osaka 540-6207 (JP)**

(72) Inventors:
• **KOGA, Tatsuo**
  **Osaka-shi, Osaka 540-6207 (JP)**
• **KIDERA, Kazunori**
  **Osaka-shi, Osaka 540-6207 (JP)**
• **OHSHIMA, Kazuya**
  **Osaka-shi, Osaka 540-6207 (JP)**
• **OHORI, Takahiro**
  **Osaka-shi, Osaka 540-6207 (JP)**
• **KANAMORI, Keita**
  **Osaka-shi, Osaka 540-6207 (JP)**

(74) Representative: **Appelt, Christian W.
Boehmert & Boehmert
Anwaltspartnerschaft mbB
Pettenkoferstrasse 22
80336 München (DE)**

(54) **ABNORMALITY DETECTION DEVICE, ABNORMALITY DETECTION METHOD, AND PROGRAM**

(57)    An anomaly detection device (10) that detects an anomaly in an object (1), the anomaly detection device includes: an analyzer (12) that performs frequency analysis of sensing data obtained from a sensor (20) that senses a physical quantity of the object (1); and a determiner (15) that determines whether an anomaly is occurring in the object (1) based on an output result output from a trained model (14) by inputting frequency analysis data of the sensing data obtained from the sensor (20) to the trained model (14) that has been trained based on at least one of frequency analysis data of sensing data of the physical quantity obtained when the object (1) is in a normal state or frequency analysis data of sensing data of the physical quantity obtained when the object (1) is in an anomalous state.

FIG. 1

**EP 4 206 699 A1**

**Description**

[Technical Field]

The present invention relates to an anomaly detection device, an anomaly detection method, and a program.

[Background Art]

Conventionally, a system is known in which DC power supplied from a photo voltaic (PV) panel (solar panel) or the like via a direct current (DC) wiring is converted into AC power by a device such as an inverter and supplied to a load. It has been reported that the DC wiring that connects such a DC power supply and a device is damaged or broken due to external factors, aged deterioration, or the like. An anomaly such as an arc failure may occur due to such damage to the DC wiring or the like. Therefore, a detection means for detecting an anomaly such as an arc failure in wiring has been proposed (for example, Patent Literature (PTL) 1).

[Citation List]

[Patent Literature]

[PTL 1] Japanese Unexamined Patent Application Publication No. 2011-7765

[Summary of Invention]

[Technical Problem]

For an anomaly detection device such as that disclosed in PTL 1, it is required to accurately detect an anomaly in an object.
Therefore, the present invention provides an anomaly detection device and the like that can accurately detect an anomaly in an object.

[Solution to Problem]

One aspect of the anomaly detection device according to the present invention is an anomaly detection device that detects an anomaly in an object, and the anomaly detection device includes: an analyzer that performs frequency analysis of sensing data obtained from a sensor that senses a physical quantity of the object; and a determiner that determines whether an anomaly is occurring in the object based on an output result obtained by inputting frequency analysis data of the sensing data obtained from the sensor to a trained model that has been trained based on at least one of frequency analysis data of sensing data of the physical quantity obtained when the object is in a normal state or frequency analysis data of sensing data of the physical quantity obtained when the object is in an anomalous state, the output result being output from the trained model.
One aspect of the anomaly detection method according to the present invention is an anomaly detection method for detecting an anomaly in an object, and the anomaly detection method includes: performing frequency analysis of sensing data obtained from a sensor that senses a physical quantity of the object; and determining whether an anomaly is occurring in the object based on an output result obtained by inputting frequency analysis data of the sensing data obtained from the sensor to a trained model that has been trained based on at least one of frequency analysis data of sensing data of the physical quantity obtained when the object is in a normal state or frequency analysis data of sensing data obtained when the object is in an anomalous state, the output result being output from the trained model.
One aspect of the program according to the present invention is a program for causing a computer to execute the anomaly detection method described above.

[Advantageous Effects of Invention]

According to one aspect of the present invention, it is possible to accurately detect an anomaly in an object.

[Brief Description of Drawings]

[FIG. 1]

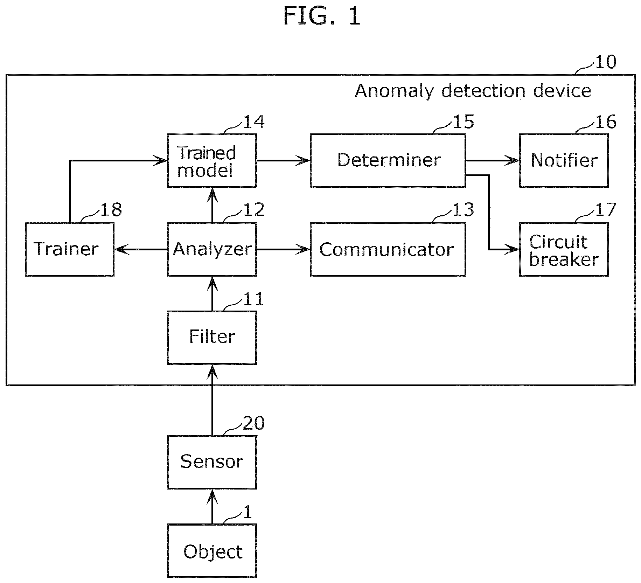

FIG. 1 is a configuration diagram illustrating an example of an anomaly detection device according to an embodiment;
[FIG. 2]

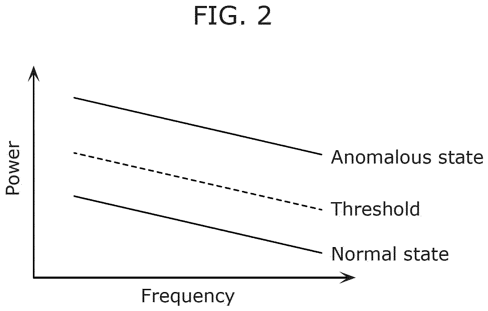

FIG. 2 is a diagram for explaining anomaly determination by a trained model constructed by logistic regression analysis.
[FIG. 3]

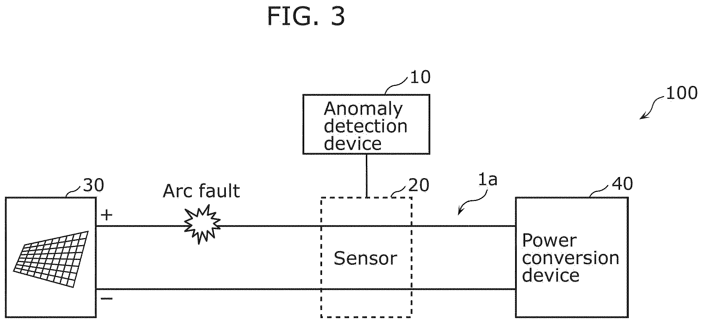

FIG. 3 is a diagram illustrating an example of a DC distribution network to which the anomaly detection device according to the embodiment is applied.
[FIG. 4]

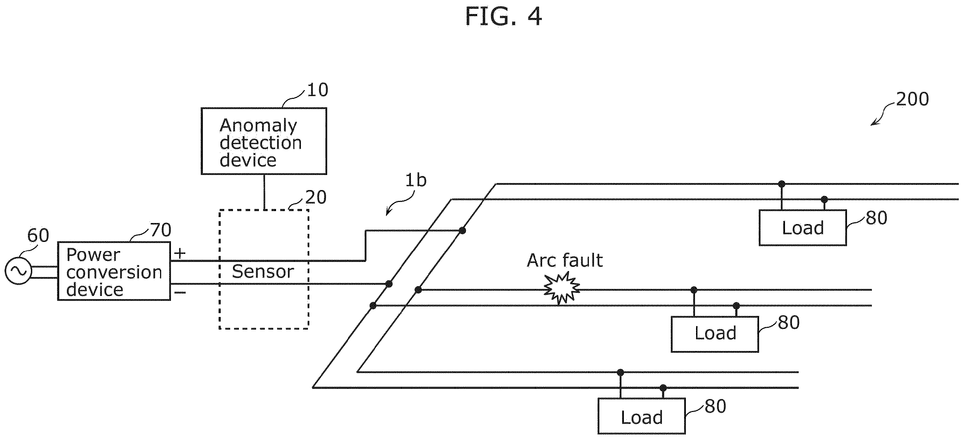

FIG. 4 is a diagram illustrating another example of a DC distribution network to which the anomaly detection device according to the embodiment is applied.
[FIG. 5]

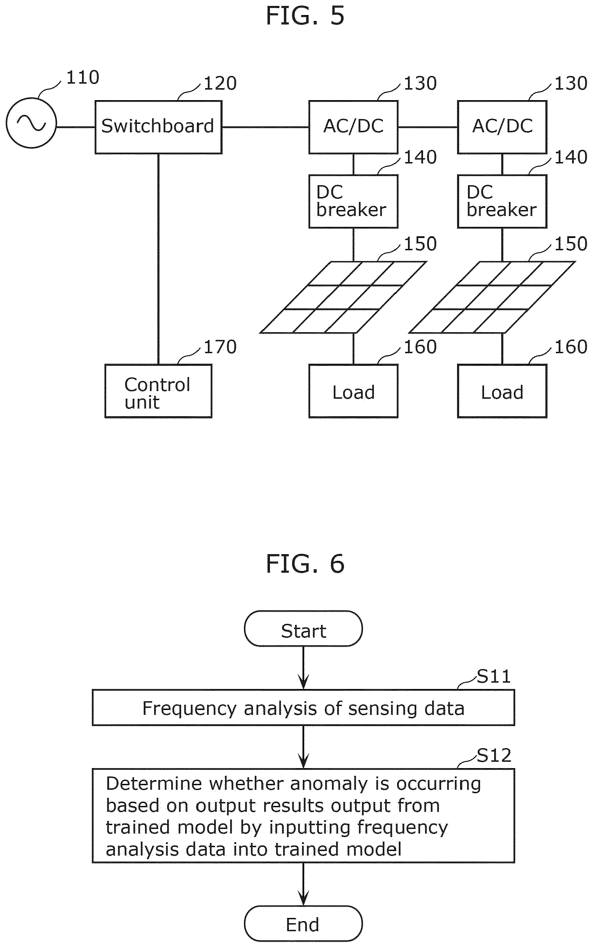

FIG. 5 is a diagram for explaining an installation location of the anomaly detection device according to the embodiment.
[FIG. 6]
FIG. 6 is a flowchart illustrating an example of an anomaly detection method according to another embodiment.

[Description of Embodiments]

Hereinafter, embodiments of the present invention will be described with reference to the drawings. All of the embodiments described below represent specific examples of the present invention. Therefore, the numerical values, shapes, materials, components, arrangement positions and connection forms of components, steps, order of steps, and the like shown in the following embodiments are examples and are not intended to limit the present invention.

It should be noted that each figure is a schematic diagram and is not necessarily exactly illustrated. In addition, in each figure, the same symbols are used to substantially identical configurations, and the overlapping description is omitted or simplified.

[Embodiment]

FIG. 1 is a configuration diagram illustrating an example of anomaly detection device 10 according to an embodiment. FIG. 1 also shows object 1 and sensor 20 in addition to anomaly detection device 10.

Object 1 is a target for anomaly detection by anomaly detection device 10. Object 1 is not particularly limited, but is, for example, a DC wiring network and the like.

Sensor 20 is a sensor that senses the physical quantity of object 1. The physical quantity includes, but is not particularly limited to, current, voltage, temperature, and the like. Sensor 20 is a sensor corresponding to the type of the physical quantity to be sensed. When the physical quantity to be sensed is current, it is an ammeter. When the physical quantity to be sensed is voltage, it is a voltmeter. When the physical quantity to be sensed is temperature, it is a thermometer. Sensor 20 outputs sensing data (for example, an electric signal) according to the magnitude of the sensed physical quantity.

Anomaly detection device 10 is a device that detects an anomaly in object 1. Anomaly detection device 10 is implemented by, for example, a microcomputer. The microcomputer is a semiconductor integrated circuit or the like including a read only memory (ROM) in which the program is stored, a random access memory (RAM), a processor (CPU: Central Processing Unit) that executes the program, a communication interface, a timer, an A/D converter, a D/A converter, and the like. It should be noted that anomaly detection device 10 may be implemented in hardware by a dedicated electronic circuit or the like including an A/D converter, a logic circuit, a gate array, a D/A converter, and the like.

Anomaly detection device 10 includes filter unit 11, analyzer 12, communicator 13, trained model 14, determiner 15, notifier 16, circuit breaker 17, and trainer 18. For example, analyzer 12, determiner 15, notifier 16, and trainer 18 are implemented by a processor executing a program stored in memory. For example, communicator 13 is implemented by a communication interface included in anomaly detection device 10. For example, trained model 14 is stored in a memory or the like included in anomaly detection device 10. It should be noted that anomaly detection device 10 may include sensor 20.

For example, sensing data obtained from sensor 20 when an anomaly is occurring in object 1 includes a signal with a frequency corresponding to the anomaly. Therefore, filter unit 11 includes a filter into which sensing data obtained from sensor 20 is input to pass a frequency corresponding to an anomaly in object 1. In other words, filter unit 11 blocks signals other than the frequency corresponding to the anomaly in object 1. The passband of the filter is appropriately determined according to the frequency of an anomaly that can occur, the frequency of noise other than the anomaly, and the like.

Analyzer 12 performs frequency analysis of the sensing data obtained from sensor 20 that senses the physical quantity of object 1. For example, analyzer 12 performs frequency analysis of sensing data obtained from sensor 20 via filter unit 11.

For example, anomaly detection device 10 can communicate with a central management system that manages anomaly detection device 10, and communicator 13 transmits the analysis result of analyzer 12 to the central management system. For example, the central management system accumulates the received analysis results or performs more detailed analysis. In addition, although the details will be described later, anomaly detection device 10 may be capable of communicating with object 1, a device connected to object 1, or the like, and when it is determined that an anomaly is occurring in object 1, communicator 13 may transmit a specific signal to object 1 or a device connected to object 1.

Trained model 14 is a model that has been trained based on at least one of frequency analysis data of sensing data of the physical quantity obtained when object 1 is in a normal state or frequency analysis data of sensing data of the physical quantity obtained when object 1 is in an anomalous state. For example, trained model 14 is a model that has been trained based on both frequency analysis data among frequency analysis data of sensing data of the physical quantity obtained when object 1 is in a normal state and frequency analysis data of sensing data of the physical quantity obtained when object 1 is in an anomalous state. It should be noted that trained model 14 may be a trained model based on either frequency analysis data among the frequency analysis data of sensing data of the physical quantity obtained when object 1 is in a normal state and the frequency analysis data of sensing data of the physical quantity obtained when object 1 is in an anomalous state.

For example, trained model 14 is trained using a large number of pre-acquired frequency analysis data as feature quantities. Specifically, trained model 14 is constructed by repeated training such that when the frequency analysis data at the time when object 1 is in a normal state is input, the output result indicating a normality is output from the model, and when the frequency analysis data at the time when object 1 is in an anomalous state is input, the output result indicating an anomaly is output from the model.

In addition, for example, trained model 14 may be a model constructed by regression analysis. For example, it is possible to determine whether the data input to trained model 14 indicates an anomaly by comparing the threshold, which is obtained from the result of regression analysis based on the frequency analysis data of sensing data of the physical quantity obtained when object 1 is in a normal state and the frequency analysis data of sensing data of the physical quantity obtained when object 1 is in an anomalous state, with the data input to trained model 14.

For example, trained model 14 may be a model constructed by logistic regression analysis.

Trained model 14 constructed by logistic regression analysis is represented by a function shown in Equation 1 and Equation 2 below. n is a natural number, $w_i$ is a regression coefficient, $x_i$ is an explanatory variable, and Z(Y) is an objective variable of trained model 14. For example, when Z(Y) obtained at the time when data is input to trained model 14 is smaller than a threshold (for example, 0.5), the input data indicates a normality, and when it is larger than the threshold, $w_i$ are trained such that the input data indicates an anomaly.

[Math. 1]

$$Z(Y) = \frac{1}{1+\exp(-Y)} \qquad \text{(Equation 1)}$$

[Math. 2]

$$Y = \sum_{i=0}^{n} w_i \cdot x_i \qquad \text{(Equation 2)}$$

FIG. 2 is a diagram for explaining anomaly determination by trained model 14 constructed by logistic regression analysis. A regression line indicating a normality can be obtained from the frequency analysis data group when object 1 is in a normal state, and a regression line indicating an anomaly can be obtained from the frequency analysis data group when object 1 is in an anomalous state. Then, the straight line (broken line) indicating the threshold can be set based on the regression line indicating the normality and the regression line indicating the anomaly. For example, the threshold is set such that the error is small.

For example, trained model 14 may be a model constructed by a support vector machine.

In addition, for example, trained model 14 may be a model constructed using the Mahalanobis' distance. For example, it is possible to determine whether the input data indicates an anomaly by the degree of deviation (Mahalanobis' distance) of the data input to trained model 14 from the frequency analysis data when object 1 is in a normal state. Alternatively, it is possible to determine whether the input data indicates a normality by the degree of deviation (Mahalanobis' distance) of the data input to trained model 14 from the frequency analysis data when object 1 is in an anomalous state.

By inputting the frequency analysis data of the sensing data obtained from sensor 20 to trained model 14, determiner 15 determines whether an anomaly is occurring in object 1 based on the output result output from trained model 14. For example, when the output result of trained model 14 indicates a normality at the time when the frequency analysis data of the sensing data obtained from sensor 20 is input to trained model 14, determiner 15 determines that no anomaly is occurring in object 1, and when the output result of trained model 14 indicates an anomaly, determiner 15 determines that an anomaly is occurring in object 1.

Notifier 16 makes a notification of the occurrence of an anomaly when it is determined that an anomaly is occurring in object 1. For example, anomaly detection device 10 may include a component (for example, a lamp, a display device, a speaker, or the like) for making a notification of the occurrence of anomaly, and when it is determined that an anomaly is occurring in object 1, a lamp may be lit to indicate the occurrence of an anomaly, a display device may be caused to display the occurrence of the anomaly, or a speaker may be caused to output a sound indicating the occurrence of the anomaly. In addition, when it is determined that an anomaly is occurring in object 1, notifier 16 may make a notification of the occurrence of an anomaly via communicator 13 to the central management system or a personal computer (PC), mobile terminal or the like owned by the user of object 1.

When it is determined that an anomaly is occurring in object 1, circuit breaker 17 cuts off the connection between the components of object 1. Circuit breaker 17 is, for example, a switch or the like attached to object 1. For example, when it is determined that an anomaly is occurring in object 1, the connection between specific components in object 1 is cut off, so that it is possible to prevent object 1 or the devices in the periphery of object 1 from becoming dangerous due to the anomaly.

It should be noted that circuit breaker 17 may not be included in anomaly detection device 10 and may be a component included in object 1. In this case, a signal for breaking the connection between specific components in object 1 may be transmitted from communicator 13 to circuit breaker 17 included in object 1, and circuit breaker 17 included in object 1 may break the connection between certain components in object 1.

Trainer 18 re-trains trained model 14 using sensing data obtained from sensor 20. That is, trained model 14 is re-trained using the latest sensing data obtained from sensor 20 and updated to the latest model.

Next, an application example of anomaly detection device 10 according to the embodiment will be described. For example, object 1 is a DC distribution network, and anomaly detection device 10 is applied to the DC distribution network.

FIG. 3 is a diagram illustrating an example of a DC distribution network to which anomaly detection device 10 according to the embodiment is applied. FIG. 3 illustrates a DC distribution network in photovoltaic power generation system 100.

Photovoltaic power generation system 100 is a system that converts DC power generated by photovoltaic power generation into AC power and outputs the AC power, and includes solar cell 30 and power conversion device 40. For example, a DC distribution network in photovoltaic system 100 is connected to solar cell 30 and power conversion device 40. Solar cell 30 and power conversion device 40 are connected to each other by DC wiring 1a in the DC distribution network. DC wiring 1a consists of a positive wiring that connects the positive electrode of solar cell 30 and power conversion device 40 and a negative wiring that connects the negative electrode of solar cell 30 and power conversion device 40.

Solar cell 30 is a DC power supply that generates DC power by generating power from sunlight. As described above, solar cell 30 includes a positive electrode and a negative electrode, a positive wiring is connected to the positive electrode, and a negative wiring is connected to the negative electrode.

Power conversion device 40 is a DC/AC converter that converts the DC power generated by solar cell 30 into AC power. It should be noted that a DC/DC converter may be connected between solar cell 30 and power conversion device 40. Power conversion device 40 converts DC power supplied from solar cell 30 through DC wiring 1a into AC power. For example, power conversion device 40 converts DC power into AC power with a frequency of 50 Hz or 60 Hz. AC power is used in household electric appliances and the like.

For example, sensor 20 is provided on DC wiring 1a in the DC distribution network. Sensor 20 includes, for example, an ammeter. The ammeter measures the current flowing through DC wiring 1a. The current measured by the ammeter is output to anomaly detection device 10 as sensing data. It should be noted that sensor 20 may include a voltmeter instead of an ammeter, or may include both an ammeter and a voltmeter. The voltmeter measures the input voltage of power conversion device 40. The input voltage of power conversion device 40 is the voltage between the positive wiring connecting the positive electrode of solar cell 30 and power conversion device 40 and the negative wiring connecting the negative electrode of solar cell 30 and power conversion device 40. The voltage measured by the voltmeter is output to anomaly detection device 10 as sensing data.

It has been reported that DC wiring causes damage or breakage due to external factors and aged deterioration. For example, an anomaly in the DC distribution network is an arc failure in DC wiring 1a connected to power conversion device 40, and such damage or the like may cause an arc failure. In this application example, anomaly detection device 10 detects an arc failure that occurs in DC wiring 1a that connects solar cell 30 and power conversion device 40.

For example, analyzer 12 performs frequency analysis of the sensing data indicating the current flowing through DC wiring 1a. For example, analyzer 12 calculates the frequency spectrum (frequency analysis data) of the current signal by Fourier transforming the time waveform of the sensing data. Then, the frequency analysis data is input to trained model 14, and determiner 15 determines whether an arc fault is occurring based on the output result of trained model 14.

For example, when it is determined that an anomaly is occurring (that is, an arc fault is occurring) in the DC distribution network, circuit breaker 17 breaks the connection by DC wiring 1a (that is, the connection between solar cell 30 and power conversion device 40). Alternatively, communicator 13 may transmit a signal for stopping power supply from power conversion device 40 to power conversion device 40 when it is determined that an arc fault is occurring.

FIG. 4 is a diagram illustrating another example of a DC distribution network to which anomaly detection device 10 according to the embodiment is applied. FIG. 4 illustrates the DC distribution network in indoor wiring system 200. It should be noted that FIG. 4 also illustrates grid power supply 60 connected to indoor wiring system 200.

System power supply 60 is a power supply that supplies AC power generated at a power plant or the like.

Indoor wiring system 200 includes power conversion device 70 and load 80. Power conversion device 70 and load 80 are installed indoors in a facility such as a detached house, collective housing, building, or factory. For example, the DC distribution network in indoor wiring system 200 is provided indoors and connected to power conversion device 70 and load 80. Power conversion device 70 and load 80 are connected with each other by DC wiring 1b (for example, duct wiring) in a DC distribution network. DC wiring 1b consists of a positive wiring that connects the positive electrode of power conversion device 70 and load 80 and a negative wiring that connects the negative electrode of power conversion device 70 and load 80.

Power conversion device 70 is an AC/DC converter that is supplied with AC power from grid power supply 60, converts the supplied AC power into DC power, and outputs the DC power. Power conversion device 70 converts AC power supplied from grid power supply 60 into DC power and outputs the DC power to load 80. Power conversion device 70 includes a positive electrode and a negative electrode, a positive wiring is connected to the positive electrode, and a negative wiring is connected to the negative electrode.

Load 80 is, for example, a device installed indoors, such as a lighting fixture, a speaker, or a microphone. Here, a plurality of loads 80 are illustrated, and DC wiring 1b is wiring branched from power conversion device 70 toward the plurality of loads 80.

For example, sensor 20 is provided on DC wiring 1b in the DC distribution network. Sensor 20 includes, for example, a voltmeter. The voltmeter measures the output voltage of power conversion device 40 (in other words, the input voltage of load 80). The output voltage of power conversion device 70 is the voltage between the positive wiring connecting the positive electrode of power conversion device 70 and load 80 and the negative wiring connecting the negative electrode of power conversion device 70 and load 80. The voltage measured by the voltmeter is output to anomaly detection device 10 as sensing data. It should be noted that FIG. 4 illustrates an example in which sensor 20 is provided between the positive wiring and the negative wiring before branching in DC wiring 1b, but when sensor 20 includes the voltmeter, it may be provided between the positive wiring and the negative wiring in any pair of the positive wiring and the negative wiring after branching. This is because the voltage between the positive wiring and the negative wiring is the same both before and after branching.

For example, an anomaly in the DC distribution network as object 1 is an arc fault in DC wiring 1b connected to power conversion device 70 and load 80. In this application example, anomaly detection device 10 detects an arc failure that occurs in DC wiring 1b that connects power conversion device 70 and load 80.

For example, analyzer 12 performs frequency analysis of the sensing data indicating the voltage in DC wiring 1b. For example, analyzer 12 calculates the frequency spectrum (frequency analysis data) of the voltage signal by Fourier transforming the time waveform of the sensing data. Then, the frequency analysis data is input to trained model 14, and determiner 15 determines whether an arc fault is occurring based on the output result of trained model 14.

For example, when it is determined that an anomaly is occurring (that is, an arc fault is occurring) in the DC distribution network, circuit breaker 17 breaks the connection by DC wiring 1b (that is, the connection between power conversion device 70 and load 80). Alternatively, when it is determined that an arc failure is occurring, communicator 13 may transmit a signal for stopping power supply from power conversion device 70 to power conversion device 70.

It should be noted that anomaly detection device 10 can be arranged in various devices connected to the DC distribution network. This will be described with reference to FIG. 5.

FIG. 5 is a diagram for explaining the installation location of anomaly detection device 10 according to the embodiment. FIG. 5 illustrates switchboard 120, AC/DC converter 130, DC breaker 140, duct wiring 150, load 160 and control unit 170 in a DC distribution network. FIG. 5 illustrates, as an example, a DC distribution network in a fairly large facility, and multiple sets (here, two sets) of AC/DC converters 130, DC breakers 140, duct wiring 150, and loads 160 may be connected to the DC distribution network. In addition, FIG. 5 also illustrates grid power supply 110 connected to switchboard 120.

Switchboard 120 converts the high voltage sent from the power plant or the like via grid power supply 110 into a voltage that can be used by a device in the facility and distributes it to each place in the facility. For example, switchboard 120 is monitored, controlled, etc. by control unit 170.

AC/DC converter 130 is supplied with AC power from switchboard 120, converts the supplied AC power into DC power, and outputs the DC power.

DC breaker 140 is a breaker for breaking the connection between AC/DC converter 130 and duct wiring 150.

Duct wiring 150 is wiring provided in the facility, which is stretched around, for example, the ceiling or the like of the facility and connected to load 160. It should be noted that duct wiring 150 may be provided on the wall or floor of the facility. In addition, although an example in which one load 160 is connected to duct wiring 150 is illustrated here, various types of loads 160 can be connected to duct wiring 150.

For example, anomaly detection device 10 may be installed in any of switchboard 120, AC/DC converter 130, DC breaker 140, and load 160. In addition, object 1 whose anomaly is detected by anomaly detection device 10 may be any of AC wiring that connects grid power supply 110 and switchboard 120, AC wiring that connects switchboard 120 and AC/DC 130, DC wiring that connects AC/DC converter 130 and DC breaker 140 and duct wiring 150 that connects DC breaker 140 and load 160.

In addition, the present invention can be implemented as an anomaly detection system, and each component in anomaly detection device 10 may be located dispersedly. For example, communicator 13 in anomaly detection device 10 may be provided in switchboard 120, AC/DC converter 130, or DC breaker 140, and other components in anomaly detection device 10 may be provided in other devices. For example, when it is determined that an anomaly is occurring, communicator 13 may transmit a signal indicating the anomaly to control unit 170 by wire, or may wirelessly transmit a signal indicating the anomaly to an external device (such as a smartphone or a PC) or the central management system.

As described above, anomaly detection device 10 according to the present embodiment is a device that detects an anomaly in object 1. Anomaly detection device 10 includes: analyzer 12 that performs frequency analysis of sensing data obtained from sensor 20 that senses a physical quantity of object 1; and determiner 15 that determines whether an anomaly is occurring in object 1 based on an output result output from trained model 14 by inputting frequency analysis data of the sensing data obtained from sensor 20 to trained model 14 that has been trained based on at least one of frequency analysis data of sensing data of the physical quantity obtained when object 1 is in a normal state or frequency analysis data of sensing data of the physical quantity obtained when object 1 is in an anomalous state.

According to this, trained model 14 is a trained model using at least one of frequency analysis data of sensing data of the physical quantity obtained when object 1 is in a normal state or frequency analysis data of sensing data of the physical quantity obtained when object 1 is in an anomalous state, so that an anomaly in object 1 can be accurately detected based on an output result of trained model 14 by inputting frequency analysis data of the sensing data obtained from sensor 20 to trained model 14.

For example, trained model 14 may be a model constructed by regression analysis.

In this way, trained model 14 may be constructed by regression analysis.

For example, trained model 14 may be a model constructed by logistic regression analysis.

According to this, a linear threshold can be set as a threshold for determining whether the frequency analysis data of the sensing data obtained from sensor 20 indicates an anomaly.

For example, trained model 14 may be a model constructed by a support vector machine.

According to this, a non-linear threshold can be set as a threshold for determining whether the frequency analysis data of the sensing data obtained from sensor 20 indicates an anomaly.

For example, trained model 14 may be a model constructed using the Mahalanobis' distance.

According to this, an anomaly in object 1 can be accurately detected by multivariate analysis using the Mahalanobis' distance.

For example, physical quantities may include current, voltage, or temperature.

According to this, an anomaly related to the current flowing through object 1, the voltage in object 1, or the temperature in object 1 can be accurately detected.

For example, object 1 may be a DC distribution network.

According to this, an anomaly that occurs in the DC distribution network as object 1 can be accurately detected.

For example, a DC distribution network may be connected to a DC power supply, a power conversion device, or a load. In addition, the anomaly in the DC distribution network may be an arcing fault in the DC wiring connected to the DC power supply, the power conversion device, or the load.

According to this, it is possible to accurately detect an arc fault that occurs in a DC distribution network to which a DC power supply, a power conversion device, or a load is connected.

In addition, anomaly detection device 10 further includes circuit breaker 17, and when it is determined that an anomaly is occurring in the DC distribution network, circuit breaker 17 may break the connection by the DC wiring connected to the DC power supply, the power conversion device, or the load.

According to this, it is possible to prevent the DC power supply, power conversion device, or load, or the DC wiring that connects them from becoming in a dangerous state.

In addition, anomaly detection device 10 further includes communicator 13, and when it is determined that an anomaly is occurring in the DC distribution network, communicator 13 may transmit a signal for stopping the power supply from the power conversion device to the power conversion device.

According to this, it is possible to prevent the DC power supply, power conversion device, or load, or the DC wiring that connects them from becoming in a dangerous state.

In addition, anomaly detection device 10 may further include notifier 16, and when it is determined that an anomaly is occurring in object 1, notifier 16 may make a notification of the occurrence of an anomaly.

According to this, it is possible to make a notification of the occurrence of an anomaly to the user of object 1 or the administrator who manages object 1.

In addition, anomaly detection device 10 may further include trainer 18 that re-trains trained model 14 using sensing data obtained from sensor 20.

According to this, it is possible to further improve the accuracy of trained model 14 according to the location where anomaly detection device 10 equipped with trained model 14 is applied or the like.

[Other Embodiments]

Although anomaly detection device 10 according to the embodiment has been described above, the present invention is not limited to the above embodiment.

For example, in the above embodiment, an example in which anomaly detection device 10 includes filter unit 11 has been described, but filter unit 11 may not be included.

For example, in the above embodiment, an example in which anomaly detection device 10 includes communicator 13 has been described, but communicator 13 may not be included.

For example, in the above embodiment, an example in which anomaly detection device 10 includes notifier 16 has been described, but notifier 16 may not be included.

For example, in the above embodiment, an example in which anomaly detection device 10 includes circuit breaker 17 has been described, but circuit breaker 17 may not be included.

For example, in the above embodiment, an example in which anomaly detection device 10 includes trainer 18 has been described, but trainer 18 may not be included.

For example, although in the above embodiment, an arc failure in a DC distribution network was described as an example of an anomaly detected by anomaly detection device 10, anomaly detection device 10 can detect anomalies such as high resistance, ground fault, short circuit, deterioration, and signs of arc failure. For example, if the anomaly is an anomaly that is correlated with a physical quantity in object 1, and if the physical quantity that is correlated with the anomaly can be frequency-analyzed as an electrical signal, the type of anomaly detected by anomaly detection device 10 is not particularly limited.

For example, the present invention can be implemented not only as anomaly detection device 10, but also as an anomaly detection method including steps (processes) performed by each component of anomaly detection device 10.

FIG. 6 is a flowchart illustrating an example of an anomaly detection method according to another embodiment.

Specifically, the anomaly detection method is a method for detecting an anomaly in an object, and the anomaly detection method includes: an analysis step (step S11) for performing frequency analysis of sensing data obtained from a sensor that senses a physical quantity of the object; and a determination step (step S12) for determining whether an anomaly is occurring in the object based on an output result output from a trained model obtained by inputting frequency analysis data of the sensing data obtained from the sensor to the trained model that has been trained based on at least one of frequency analysis data of sensing data of the physical quantity obtained when the object is in a normal state or frequency analysis data of sensing data obtained when the object is in an anomalous state.

For example, those steps may be executed by a computer (computer system). Then, the present invention can be implemented as a program for causing a computer to execute the steps included in those methods. Furthermore, the present invention can be implemented as a non-transitory computer-readable recording medium such as a CD-ROM recording the program.

Although anomaly detection device 10 according to the above embodiment is implemented in software by a microcomputer, it may be implemented in software in a general-purpose computer such as a personal computer. Furthermore, anomaly detection device 10 may be implemented in hardware by a dedicated electronic circuit configured by an A/D converter, a logic circuit, a gate array, a D/A converter, and the like.

In addition, forms obtained by applying various modifications to each embodiment conceived by a person skilled in the art or forms realized by arbitrarily combining the components and functions in each embodiment without departing from the spirit of the present invention are also included in this invention.

[Reference Signs List]

| 1 | Object |
|---|---|
| 1a, 1b | DC wiring |
| 10 | Anomaly detection device |
| 12 | Analyzer |
| 13 | Communicator |
| 14 | Trained model |
| 15 | Determiner |
| 16 | Notifier |
| 17 | Circuit breaker |
| 18 | Trainer |
| 20 | Sensor |
| 40, 70 | Power converter |
| 80, 160 | Load |

**Claims**

1. An anomaly detection device that detects an anomaly in an object, the anomaly detection device comprising:

   an analyzer that performs frequency analysis of sensing data obtained from a sensor that senses a physical quantity of the object; and
   a determiner that determines whether an anomaly is occurring in the object based on an output result obtained by inputting frequency analysis data of the sensing data obtained from the sensor to a trained model that has been trained based on at least one of frequency analysis data of sensing data of the physical quantity obtained when the object is in a normal state or frequency analysis data of sensing data of the physical quantity obtained when the object is in an anomalous state, the output result being output from the trained model.

2. The anomaly detection device according to claim 1,
   wherein the trained model is a model constructed by regression analysis.

3. The anomaly detection device according to claim 2,
   wherein the trained model is a model constructed by logistic regression analysis.

4. The anomaly detection device according to claim 2,
   wherein the trained model is a model constructed by a support vector machine.

5. The anomaly detection device according to claim 1,
   wherein the trained model is a model constructed using a Mahalanobis' distance.

6. The anomaly detection device according to any one of claims 1 to 5,
   wherein the physical quantity includes current, voltage, or temperature.

7. The anomaly detection device according to any one of claims 1 to 6,
   wherein the object is a DC distribution network.

8. The anomaly detection device according to claim 7,
   wherein the DC distribution network is connected to a DC power supply, a power conversion device, or a load.

9. The anomaly detection device according to claim 8,
   wherein an anomaly in the DC distribution network is an arc fault in a DC wiring connected to the DC power supply, the power conversion device, or the load.

10. The anomaly detection device according to claim 8 or 9, further comprising:

    a circuit breaker,
    wherein when it is determined that an anomaly is occurring in the DC distribution network, the circuit breaker cuts off a connection by a DC wiring connected to the DC power supply, the power conversion device, or the load.

**11.** The anomaly detection device according to any one of claims 8 to 10, further comprising:

a communicator,
wherein when it is determined that an anomaly is occurring in the DC distribution network, the communicator transmits a signal for stopping power supply from the power conversion device to the power conversion device.

**12.** The anomaly detection device according to any one of claims 1 to 11, further comprising:

a notifier,
wherein when it is determined that an anomaly is occurring in the object, the notifier makes a notification of occurrence of the anomaly.

**13.** The anomaly detection device according to any one of claims 1 to 12,
wherein the anomaly detection device further comprises a trainer that re-trains the trained model using the sensing data obtained from the sensor.

**14.** An anomaly detection method for detecting an anomaly in an object, the anomaly detection method comprising:

performing frequency analysis of sensing data obtained from a sensor that senses a physical quantity of the object; and
determining whether an anomaly is occurring in the object based on an output result obtained by inputting frequency analysis data of the sensing data obtained from the sensor to a trained model that has been trained based on at least one of frequency analysis data of sensing data of the physical quantity obtained when the object is in a normal state or frequency analysis data of sensing data obtained when the object is in an anomalous state, the output result being output from the trained model.

**15.** A program for causing a computer to execute the anomaly detection method according to claim 14.

FIG. 1

FIG. 2

EP 4 206 699 A1

# FIG. 3

FIG. 4

# FIG. 5

110  120  130  130

Switchboard — AC/DC — AC/DC

140  140

DC breaker  DC breaker

150  150

170  160  160

Control unit  Load  Load

# FIG. 6

Start

↓

Frequency analysis of sensing data  S11

↓

Determine whether anomaly is occurring based on output results output from trained model by inputting frequency analysis data into trained model  S12

↓

End

## INTERNATIONAL SEARCH REPORT

International application No.

**PCT/JP2021/027126**

### A. CLASSIFICATION OF SUBJECT MATTER

*G01R 31/08*(2020.01)i; *G01R 31/58*(2020.01)i
FI:  G01R31/08; G01R31/58

According to International Patent Classification (IPC) or to both national classification and IPC

### B. FIELDS SEARCHED

Minimum documentation searched (classification system followed by classification symbols)

G01R31/08; G01R31/58; G01R31/00; G01R31/12

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 8-271573 A (TOKYO ELECTRIC POWER CO INC) 18 October 1996 (1996-10-18) paragraphs [0001], [0014]-[0046], fig. 1-7 | 1, 6, 13-15 |
| Y | | 2-5, 7-12 |
| Y | WO 2020/039581 A1 (TECH RES ASSOCIATION FUTURE ADDITIVE MANUFACTURING) 27 February 2020 (2020-02-27) paragraph [0070] | 2-4 |
| Y | WO 2006/087854 A1 (SHARP KK) 24 August 2006 (2006-08-24) paragraph [0003] | 5 |
| Y | JP 2014-134445 A (MITSUBISHI ELECTRIC CORP) 24 July 2014 (2014-07-24) paragraphs [0001], [0008], [0010]-[0023], fig. 1-9 | 7-12 |
| A | JP 2008-167645 A (GENERAL ELECTRIC CO <GE>) 17 July 2008 (2008-07-17) entire text, all drawings | 1-15 |
| A | JP 2019-200068 A (NISSIN ELECTRIC CO LTD) 21 November 2019 (2019-11-21) entire text, all drawings | 1-15 |

☑ Further documents are listed in the continuation of Box C.   ☑ See patent family annex.

| | | |
|---|---|---|
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" | document member of the same patent family |
| "P" document published prior to the international filing date but later than the priority date claimed | | |

| Date of the actual completion of the international search | Date of mailing of the international search report |
|---|---|
| **01 October 2021** | **12 October 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

International application No.

**PCT/JP2021/027126**

## C.    DOCUMENTS CONSIDERED TO BE RELEVANT

| Category* | Citation of document, with indication, where appropriate, of the relevant passages | Relevant to claim No. |
|---|---|---|
| A | JP 2019-191142 A (MEIDENSHA ELECTRIC MFG CO LTD) 31 October 2019 (2019-10-31) entire text, all drawings | 1-15 |
| A | JP 2000-224723 A (HITACHI LTD) 11 August 2000 (2000-08-11) entire text, all drawings | 1-15 |
| A | JP 5-333079 A (MITSUBISHI ELECTRIC CORP) 17 December 1993 (1993-12-17) entire text, all drawings | 1-15 |

Form PCT/ISA/210 (second sheet) (January 2015)

INTERNATIONAL SEARCH REPORT
Information on patent family members

International application No.

**PCT/JP2021/027126**

| Patent document cited in search report | | | Publication date (day/month/year) | Patent family member(s) | | | Publication date (day/month/year) |
|---|---|---|---|---|---|---|---|
| JP | 8-271573 | A | 18 October 1996 | (Family: none) | | | |
| WO | 2020/039581 | A1 | 27 February 2020 | (Family: none) | | | |
| WO | 2006/087854 | A1 | 24 August 2006 | US paragraph [0003] | 2008/0114564 | A1 | |
| JP | 2014-134445 | A | 24 July 2014 | (Family: none) | | | |
| JP | 2008-167645 | A | 17 July 2008 | US | 2008/0157781 | A1 | |
| | | | | entire text, all drawings | | | |
| | | | | EP | 1939995 | A2 | |
| | | | | KR | 10-2008-0063128 | A | |
| | | | | CA | 2614426 | A1 | |
| | | | | CN | 101210948 | A | |
| JP | 2019-200068 | A | 21 November 2019 | (Family: none) | | | |
| JP | 2019-191142 | A | 31 October 2019 | (Family: none) | | | |
| JP | 2000-224723 | A | 11 August 2000 | US | 2001/0040459 | A1 | |
| | | | | entire text, all drawings | | | |
| | | | | EP | 1024573 | A2 | |
| | | | | CN | 1262540 | A | |
| | | | | KR | 10-2001-0006591 | A | |
| JP | 5-333079 | A | 17 December 1993 | US | 5419197 | A | |
| | | | | entire text, all drawings | | | |
| | | | | EP | 572767 | A2 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2011007765 A